# EUROPÄISCHE PATENTSCHRIFT

(11) **EP 1 762 852 B1**
(45) Veröffentlichungstag und Bekanntmachung des Hinweises auf die Patenterteilung: **15.12.2010**
(21) Anmeldenummer: 06016005.8
(22) Anmeldetag: 01.08.2006
(51) Int. Cl.: G01R 15/20

(54) **Vorrichtung und Verfahren zur Messung eines in einem elektrischen Leiter fliessenden Stromes**
Device and method for measuring a current flowing in an electric conductor
Dispositif et procédé pour mesurer un courant passant dans un conducteur électrique

(30) Priorität: 25.08.2005 DE 102005040316
(43) Veröffentlichungstag der Anmeldung: 14.03.2007
(73) Patentinhaber: Lisa Dräxlmaier GmbH, 84137 Vilsbiburg (DE)
(72) Erfinder: Hausperger, Christian, 84155 Bonbruck (DE); Kindler, Edgar, 84036 Landshut (DE)
(74) Vertreter: HOFFMANN EITLE

(56) Entgegenhaltungen:
- EP-A- 1 450 176
- DE-A1- 10 240 242
- DE-A1- 10 331 883
- SU-A1- 789 833
- US-A- 5 475 301

## Beschreibung

Die vorliegende Erfindung betrifft eine Vorrichtung zur Messung eines in einem elektrischen Leiter fließenden Stromes gemäß dem Oberbegriff des Anspruchs 1 sowie ein Verfahren zum Messen eines in einem elektrischen Leiter fließenden Stromes gemäß dem Oberbegriff des Anspruchs 18.

Im Bereich der Fahrzeugtechnik führt die steigende Anzahl von elektrischen Verbrauchern in den Kraftfahrzeugen zu einem stetig steigenden Energiebedarf im Bordnetz. Hierdurch wird insbesondere die Bordbatterie immer stärker belastet, die während des Betriebs des Fahrzeugmotors als Puffer dient und im abgeschalteten Zustand des Motors die Spannungsversorgung des Fahrzeuges aufrecht erhält. Insbesondere bei vermehrtem Einsatz des Fahrzeugs im Kurzstreckenbetrieb kann dies dazu führen, dass die Batterie während des Betriebs des Motors nicht mehr vollständig geladen wird. Dies kann darin resultieren, dass das Fahrzeug mit entladener Batterie liegen bleibt oder sich aufgrund zu niedriger Batteriespannung nicht mehr starten lässt.

Um dies zu vermeiden, wird in Fahrzeugen zunehmend ein Energiemanagement eingesetzt. Ein solches Energiemanagement hat dafür zu sorgen, dass der Ladezustand der Batterie keinen kritischen Zustand erreicht und hat für eine positive Ladungsbilanz der Batterie zu sorgen. Grundlage für ein derartiges System bildet die Analyse des Batteriezustandes, der sich aus den Messgrößen Batteriestrom, Batteriespannung und Batterietemperatur ergibt. Hierbei ist vor allem die Erfassung des Lade- bzw. Entladestroms von entscheidender Bedeutung, um die Batterie auf einem unkritischen Ladeniveau zu halten und die Startfähigkeit des Fahrzeugs zu sichern.

Die Herausforderung bei der Erfassung des Lade- bzw. Entladestroms liegt darin, dass die zu messenden Ströme sich über einen sehr großen Bereich erstrecken, beispielsweise von -200 A bis 1500 A. Ein geeigneter Sensor für das Energiemanagement in Fahrzeugen muss entsprechend diesen weiten Bereich abdecken, also eine hohe Dynamik aufweisen.

### Stand der Technik

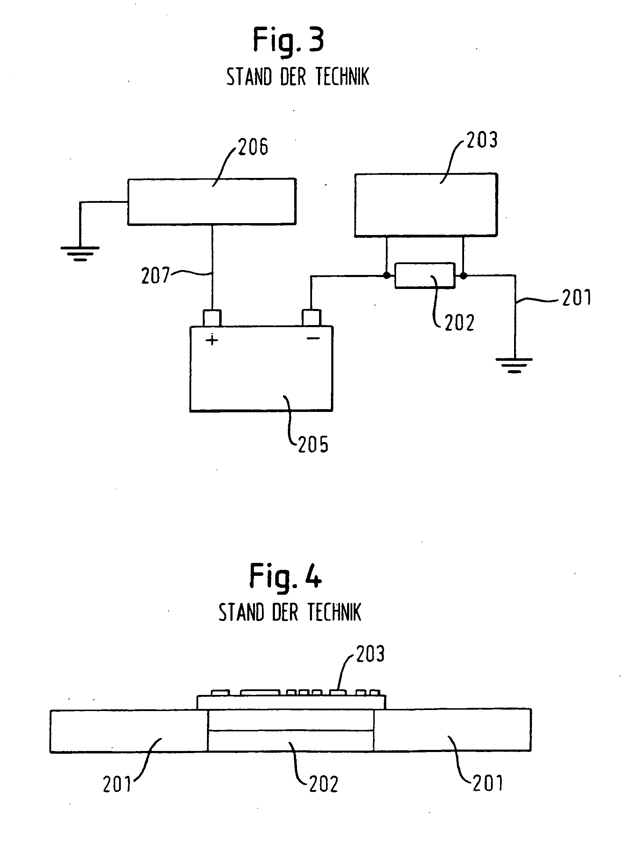

Aus dem Stand der Technik ist der in den Figuren 3 und 4 gezeigte Sensor zur Anwendung in einem Kraftfahrzeug zur Überwachung der fließenden Ströme bekannt. Zur Erfassung des Batteriestroms wird ein Messwiderstand 202 in die Masseleitung 201 eingefügt. Eine geeignete Auswerteelektronik 203 misst direkt den Spannungsabfall am Messwiderstand und berechnet hieraus den fließenden Strom. Der Messwiderstand kann dabei beispielsweise aus Manganin bestehen.

In Figur 3 ist der mit diesem Sensor zu realisierende Messaufbau gezeigt. Eine Autobatterie 205 ist über eine Masseleitung 201 mit der Fahrzeugmasse verbunden. Der Sensor bestehend aus dem Messwiderstand 202 und der Auswerteelektronik 203 ist in die Masseleitung 201 integriert. Elektrische Verbraucher 206 des Kraftfahrzeuges sind mit dem Pluspol der Batterie 205 über eine Leitung 207 verbunden.

Nachteilig an dieser aus dem Stand der Technik bekannten Lösung ist, dass der Messwiderstand in den stromführenden Leiter integriert werden muss, was einen zusätzlichen konstruktiven Aufwand verursacht, da sicherzustellen ist, dass Scher- und Zugkräfte vom Messwiderstand ferngehalten werden. Eine Verformung des Messwiderstandes kann das Messergebnis beeinflussen und führt im Extremfall zum Defekt des Sensors. Ein weiterer Nachteil ist, dass über dem Messwiderstand notwendig eine Verlustleistung abfällt. Auch bei Verwendung kleiner Widerstände, beispielsweise eines 100 mW Messwiderstandes fällt dennoch Verlustwärme ab, die abgeleitet werden muss.

Die EP 1 450 176 A1, welche den Oberbegriff des Anspruchs 1 bildet, bezieht sich auf einen magnetischen Feldsensor und einen elektrischen Stromsensor, welcher mit diesem ausgestattet ist.

Die DE 103 31 883 A1 bezieht sich auf ein Messverfahren und eine Messanordnung zum Messen von Strömen mit einem großen Dynamikbereich.

Die DE 102 40 242 A1 bezieht sich auf einen Stromsensor mit orthogonaler Ummagnetisiereinrichtung.

US 5,475,301 bezieht sich auf einen Gleichstromsensor, welcher einen kontinuierlichen, ringförmig geformten Detektionskern verwendet.

Weiterhin wird die SU 789833 A1 genannt.

### Aufgabe der Erfindung

Ausgehend von diesem Stand der Technik ist es Aufgabe der vorliegenden Erfindung, eine Vorrichtung und ein Verfahren zur Messung eines in einem elektrischen Leiter fließenden Stroms anzugeben, die die Nachteile des Standes der Technik verringern und eine zuverlässige Messung eines Stromes in einem elektrischen Leiter über einen weiten Messbereich ermöglichen.

### Beschreibung der Erfindung

Diese Aufgabe wird durch eine Vorrichtung zur Messung eines in einem elektrischen Leiter fließenden Stromes gemäß Anspruch 1 sowie durch ein Verfahren zur Messung eines in einem elektrischen Leiter fließenden Stromes gemäß Anspruch 18 gelöst.

Die Vorrichtung weist einen mit einem Luftspalt versehenen Magnetkreis zur Kupplung mit dem elektrischen Leiter und ein in dem Luftspalt des Magnetkreises angeordnetes magnetfeldsensitives Bauteil zur Messung des vom elektrischen Leiter erzeugten Magnetfeldes auf. Erfindungsgemäß sind in dem Luftspalt des Magnetkreises zwei Steuerkerne zur Steuerung des Luftspaltes angeordnet, wobei die Steuerkerne jeweils eine Steuerwicklung zur magnetischen Sättigung des jeweiligen Steuerkerns zur Steuerung der effektiven Länge des Luftspalts aufweisen und das magnetfeldsensitive Bauteil zwischen den Steuerkernen angeordnet ist.

Durch die Anordnung des magnetfeldsensitiven Bauteils zwischen den Steuerkernen ist das magnetfeldsensitive Bauteil im Wesentlichen in der Mitte des Luftspalts des Magnetkreises angeordnet. Sind die beiden Steuerkerne ungesättigt, so entspricht die effektive Luftspaltlänge im Wesentlichen der Ausdehnung des magnetfeldsensitiven Bauelementes. Werden hingegen beide Steuerkerne durch Aufbringung eines Stroms auf die Steuerwicklung gesättigt, so werden die Steuerkerne für den Magnetkreis unwirksam. Das magnetfeldsensitive Bauteil befindet sich dann in der Mitte des so erzeugten Gesamtluftspalts, der um die Länge der nun gesättigten und damit unwirksamen Steuerkerne vergrößert ist.

Die so aufgebaute Vorrichtung besitzt durch ihren speziellen Aufbau eine Messbereichsumschaltung, die durch das Bestromen der Steuerwicklungen der Steuerkerne realisiert wird. Bei Bestromung der Steuerwicklungen der Steuerkerne und der damit einhergehenden magnetischen Sättigung der Steuerkerne wird erreicht, dass die Steuerkerne unwirksam werden für den Magnetkreis. Dadurch wird der effektive Luftspalt des Magnetkreises vergrößert und dadurch das im Magnetkreis gebundene Feld abgeschwächt. Auf diese Weise können mit dem magnetfeldsensitiven Element große Ströme, die große Magnetfelder in dem Magnetkreis induzieren, gemessen werden, da das im Magnetkreis gebundene Feld bei großen Strömen durch den vergrößerten Luftspalt abgeschwächt wird.

Auf der anderen Seite, zur Messung kleinerer Ströme, werden die Steuerwicklungen der Steuerkerne abgeschaltet, so dass die Steuerkerne einen weiteren Bereich des Luftspaltes mit magnetisierbarem Material ausfüllen. Der effektive Luftspalt besteht daher bei abgeschalteten Steuerwicklungen nur aus dem magnetfeldsensitiven Bauelement.

Dadurch wird die Dynamik des magnetfeldsensitiven Bauteils besonders gut ausgenutzt. Insbesondere kann vermieden werden, dass das zu messende Magnetfeld die vorhandene Dynamik des magnetfeldsensitiven Bauteils überschreitet und es damit zu Fehlmessungen kommt. Die Vorrichtung erlaubt es daher, durch die Anpassung des zu messenden Magnetfeldes mittels der Veränderung der effektiven Länge des Luftspalts eine effektive Messbereichsumschaltung zu gewährleisten.

Durch den Aufbau mit zwei separaten Steuerkernen und der Anordnung des magnetfeldsensitiven Bauteils zwischen diesen ist das magnetfeldsensitive Bauteil, z.B. ein Hallsensor, im mittleren Bereich des Luftspalts angeordnet. Werden diese beiden Kerne durch ein Bestromen der Steuerwicklung gezielt gesättigt, so befindet sich der Hallsensor in der Mitte des dann resultierenden effektiven Luftspalts. An dieser Stelle ist das gebundene Magnetfeld am geringsten, wodurch höchstmögliche Ströme gemessen werden können.

Darüber hinaus lässt sich durch das Vorsehen zweier separater Steuerkerne eine dreistufige Umschaltung realisieren, nämlich eine Umschaltung zwischen einem Zustand, in dem kein einziger Steuerkern gesättigt ist, einem Zustand in dem ein einziger Steuerkern gesättigt ist und einem Zustand in dem beide Steuerkerne gesättigt sind.

Wird der Sensor mit hoher Empfindlichkeit betrieben, sind also die Steuerwicklungen abgeschaltet, misst das magnetfeldsensitive Bauteil das im gesamten Magnetkreis geführte Magnetfeld. Der gesamte Magnetkreis besteht dann aus dem Magnetkreis plus den Steuerkernen. Bei eingeschalteten Steuerwicklungen befindet sich das magnetfeldsensitive Bauelement genau an der Position in dem nun effektiven Luftspalt, an der das Magnetfeld am schwächsten ist, nämlich in der Mitte des Luftspalts. Es wird dadurch die maximal erreichbare Messbereichsumschaltung erzielt. Der Messbereich wird entsprechend maximiert.

Vorteilhaft weisen die Steuerkerne eine erste Sättigungsmagnetisierung auf und der Magnetkreis eine zweite Sättigungsmagnetisierung, wobei die erste Sättigungsmagnetisierung größer, kleiner oder gleich der zweiten Sättigungsmagnetisierung ist. Hierdurch kann, je nach Auslegung der Sättigungsmagnetisierungen, erreicht werden, dass bereits beim Anlegen kleiner Steuerströme an die Steuerwicklungen eine Sättigung der Steuerkerne erreicht werden kann. Bei hohen Sättigungsmagnetisierungen der Steuerkerne hingegen wird vermieden, dass eventuell vorhandene Leckströme bereits eine Messbereichsumschaltung erzeugen.

In einer Variante dieser Ausführungsform können die beiden Steuerkerne unterschiedliche Sättigungsmagnetisierungen aufweisen.

Um eine zuverlässige Messung des in dem elektrischen Leiter fließenden Stromes zu erreichen, umgreift der Magnetkreis den elektrischen Leiter im Wesentlichen in einer bevorzugten Ausführungsform.

Für eine effektive Messbereichsumschaltung ist es von Vorteil, wenn die Steuerkerne den Luftspalt im Wesentlichen ausfüllen. Besonders vorteilhaft ist es hier, wenn die Steuerkerne und das magnetfeldsensitive Bauteil den Luftspalt des Magnetkreises vollständig ausfüllen. Dabei ist es von Vorteil, wenn die Steuerkerne die gleichen Abmessungen haben, da hierdurch ein symmetrischer Aufbau gewährleistet wird. Hierdurch wird erreicht, dass sich das magnetfeldsensitive Bauteil beim Aufbringen eines Steuerstroms auf die Steuerwicklungen der Steuerkerne genau in der Mitte des dann entstehenden Luftspaltes befindet. Im anderen Fall, bei dem beide Steuerwicklungen abgeschaltet sind, befindet sich das magnetfeldsensitive Bauteil im kleinstmöglichen Luftspalt zwischen den beiden Steuerkernen. Hierdurch wird eine besonders große Messbereichsumschaltung realisiert, die sowohl kleine Ströme als auch besonders große Ströme messen kann.

Mit Vorteil sind die Steuerkerne als Ferritkerne ausgebildet. Dabei werden die Ferritkerne besonders bevorzugt als rechteckige Rahmen ausgebildet, die auf mindestens einer Seite des Rahmens eine Steuerwicklung zur Sättigung des Ferritkerns tragen. In einer besonders effizienten Anordnung sind Steuerwicklungen auf zwei gegenüberliegenden Seiten des Rahmens angeordnet. Durch die Ausbildung des Steuerkerns in dieser Form kann eine effiziente Sättigung des Steuerkerns erreicht werden, durch die eine effiziente Messbereichsumschaltung möglich wird.

In einer bevorzugten Ausführungsform sind die beiden Rahmen der jeweiligen Steuerkerne so ausgerichtet, dass die in den jeweiligen Rahmen liegenden Ebenen zueinander parallel sind. In einer besonders bevorzugten Ausführungsform sind die beiden Rahmen so ausgerichtet, dass die in den jeweiligen Rahmen liegenden Ebenen senkrecht aufeinander stehen. Durch diese Anordnung, in der die beiden Ebenen senkrecht aufeinander stehen, wird die Kontaktfläche mit dem magnetfeldsensitiven Bauteil weitest möglich minimiert. Mit anderen Worten wird die Fläche des Luftspaltes, in dem das magnetfeldsensitive Bauteil platziert ist, minimiert. Dadurch wird die Messempfindlichkeit im ungesättigten Betrieb für kleine Ströme weiter verbessert.

Mit Vorteil ist eine Auswertungsvorrichtung vorgesehen, die Steuermittel zur separaten Anregung der Steuerwicklungen aufweist. Hierdurch wird erreicht, dass durch Auswahl der jeweiligen Anregung eine Messbereichsumschaltung in einem weiten Bereich stattfinden kann. Mit Vorteil ist die Auswertungsvorrichtung mit dem magnetfeldsensitiven Bauteil integriert.

Bevorzugt ist die Vorrichtung im Bereich eines Masseleiters oder eines Plusleiters einer Fahrzeugbatterie, insbesondere einer Kraftfahrzeugbatterie angeordnet. Die Vorrichtung ist mit Vorteil im Bereich eines elektrischen Verbrauchers oder einer Gruppe elektrischer Verbraucher eines Fahrzeugs, insbesondere eines Kraftfahrzeugs angeordnet. Hierdurch lässt sich zum Einen eine Leckstromüberwachung und eine Lade- bzw. Entladestromüberwachung einfach realisieren, zum Anderen kann die Stromaufnahme einzelner Verbraucher bzw. einzelner Verbrauchergruppen in einem Fahrzeug überwacht werden.

Das Verfahren zum Messen eines in einem elektrischen Leiter fließenden Stroms kann mittels der oben beschriebenen Vorrichtung vorgenommen werden. Dabei wird erfindungsgemäß zur Messung des Stromes mindestens eine Messung des Magnetfeldes in dem Magnetkreis ohne Anregung der Steuerkerne und eine weitere Messung des Magnetfeldes in dem Magnetkreis bei gesättigten Steuerkernen durchgeführt. Eine weitere Messung kann mit Vorteil bei Sättigung nur eines einzigen Steuerkerns vorgenommen werden. In einer weiteren Ausführungsform des Verfahrens kann eine Messung zunächst bei Sättigung eines ersten Steuerkernes und dann bei Sättigung des zweiten Steuerkernes vorgenommen werden.

Hierdurch wird eine doppelte oder dreifache Messbereichsumschaltung ermöglicht, so dass Ströme in einem weiten Bereich zuverlässig gemessen werden können.

Die Erfindung bezieht sich weiterhin auf eine Verwendung der Vorrichtung in einem Kraftfahrzeug zur Überwachung von Strömen im Bordnetz des Kraftfahrzeuges und weiterhin auf eine Verwendung des beschriebenen Verfahrens in dem Kraftfahrzeug zur Überwachung von Strömen im Bordnetz eines Kraftfahrzeugs. Die beschriebene Vorrichtung bzw. das beschriebene Verfahren kann aber auch in anderen Anwendungsbereichen als Stromsensor zum Einsatz kommen.

### Kurzbeschreibung der Zeichnungen

Die Erfindung wird nachfolgend anhand bevorzugter Ausführungsformen beispielhaft beschrieben. Für gleiche Bauteile werden dabei einheitliche Bezugszeichen verwendet.

Die Zeichnungen zeigen:
- Figur 1: eine schematische Darstellung der Vorrichtung in einer ersten Ausführungsform;
- Figur 2: eine schematische Ansicht eines Stromsensors in einer zweiten Ausführungsform;
- Figur 3: eine schematische Darstellung eines Sensors zur Batteriestrommessung gemäß dem Stand der Technik; und
- Figur 4: eine Schnittdarstellung des Messwiderstandes und der Auswertelektronik aus der Figur 3 gemäß dem Stand der Technik.

### Ausführliche Beschreibung der Zeichnungen

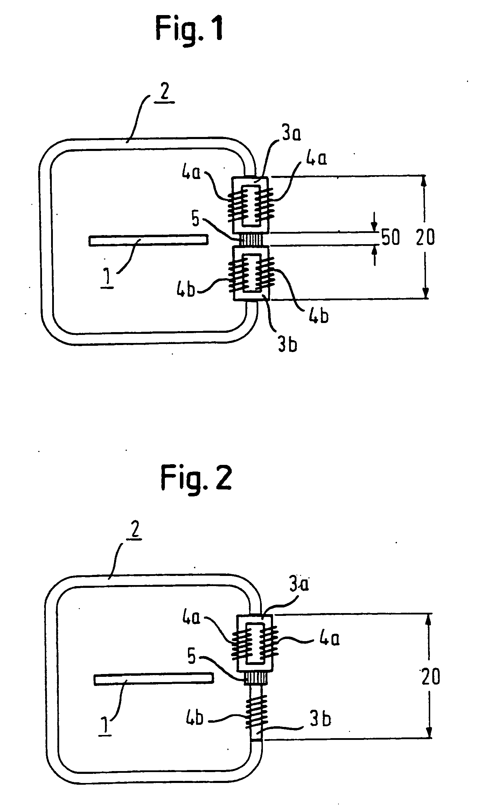

Figur 1 zeigt schematisch eine mögliche erste Ausführungsform einer Vorrichtung zur Messung eines in einem elektrischen Leiter fließenden Stromes. Die Vorrichtung dient zur Messung eines einen elektrischen Leiter 1 durchfließenden Stromes. Die Vorrichtung umfasst einen im Wesentlichen quadratischen Magnetkreis 2, der einen Luftspalt 20 aufweist. In dem Luftspalt 20 sind zwei Steuerkerne 3a und 3b angeordnet. Die Steuerkerne 3a und 3b schließen an ihren jeweiligen, dem Magnetkreis 2 zugewendeten Seiten direkt an den Magnetkreis 2 an. Die Steuerkerne 3a, 3b sind in der gezeigten Ausführungsform als Ferritkerne ausgebildet, die einen rechteckigen Rahmen bilden. Auf den beiden langen Seiten des rechteckigen Ferritkernrahmens 3a, 3b sind jeweils Steuerspulen 4a und 4b aufgebracht. Zwischen den beiden Steuerkernen 3a, 3b ist ein Spalt 50 ausgebildet, in dem ein magnetfeldsensitives Bauelement 5 angeordnet ist. Das magnetfeldsensitive Bauelement 5 ist im gezeigten Ausführungsbeispiel ein Hallsensor. Die beiden Steuerkerne 3a, 3b und das magnetfeldsensitive Bauelement 5 füllen den Luftspalt 20 des Magnetkreises 2 vollständig aus. In einem nicht gezeigten Ausführungsbeispiel ist der Luftspalt 20 des Magnetkreises 2 allerdings nicht vollständig ausgefüllt, sondern beispielsweise zwischen den Steuerkernen und dem magnetfeldsensitiven Bauteil ein Luftspalt vorgesehen.

Zur Messung des den elektrischen Leiter 1 umgebenden Magnetfeldes und damit zur Messung des den elektrischen Leiter durchfließenden Stromes wird das in den Magnetkreis 2 eingekoppelte Magnetfeld im magnetfeldsensitiven Bauteil 5 gemessen.

Sind die Ströme, die den elektrischen Leiter 1 durchfließen, klein, so wird, um die Empfindlichkeit der Vorrichtung hoch einzustellen, keinerlei Strom an die Steuerwicklungen 4a, 4b angelegt. Der Luftspalt des effektiven Magnetkreises ist dann nur in der Größenordnung des Luftspaltes zwischen den beiden Steuerkernen 3a, 3b, der der Breite des Bauteils 5 entspricht. Das im Magnetkreis 2 gebundene Magnetfeld wird daher bis zum magnetfeldsensitiven Bauteil transportiert.

Sollen jedoch große Ströme gemessen werden, so wird ein Steuerstrom auf die Steuerspulen 4a, 4b aufgebracht, so dass die Steuerkerne 3a, 3b gesättigt werden. Der Luftspalt des Magnetkreises 2 entspricht daher effektiv dem Luftspalt 20, da die gesättigten Steuerkerne nichts mehr zum Magnetkreis beitragen. Das magnetfeldsensitive Bauteil 5 liegt dann in dem vorliegenden Ausführungsbeispiel in der Mitte des Luftspalts 20 des Magnetkreises 2. An dieser Stelle ist das Magnetfeld des Magnetkreises 2 am schwächsten. Daher kann in dieser Anordnung ein besonders großer Strom des elektrischen Leiters 1 gemessen werden, ohne die Dynamik des magnetfeldsensitiven Bauteils zu überschreiten.

In Figur 2 ist eine zweite mögliche Ausführungsform gezeigt. Die Ausführungsform der Figur 2 unterscheidet sich von der in der Figur 1 gezeigten lediglich durch die Anordnung des zweiten Steuerkerns 3b bezüglich des ersten Steuerkerns 3a. Die Ebene, die im Rahmen des Steuerkerns 3b liegt, ist hier um 90 Grad gegenüber der Ebene, die im Steuerkern 3a liegt, gedreht. Hierdurch kann erreicht werden, dass die Fläche des Luftspalts minimiert wird und dadurch die Empfindlichkeit der Vorrichtung für geringe Ströme weiter verbessert wird. Die Fläche des Luftspalts entspricht dabei einer quadratischen Fläche mit einer Kantenlänge, die der Breite des Ferritkernrahmens 3a bzw. 3b entspricht. Hierdurch kann eine weitere Erhöhung der Empfindlichkeit der Vorrichtung bei geringen Strömen erreicht werden.

In einer bevorzugten Betriebsweise ist das magnetfeldsensitive Bauteil 5 mit einer Auswertungsvorrichtung (nicht gezeigt) verbunden, die Steuermittel (nicht gezeigt) zur separaten Anregung der Steuerwicklungen 4a, 4b aufweist. Durch separate Anregung der Steuerwicklungen 4a, 4b kann ein Messvorgang zur Messung der Ströme erreicht werden, bei dem in einem ersten Messbereich keinerlei Anregung auf die Steuerwicklungen 4a, 4b aufgebracht wird, in einem zweiten Messbereich eine der Steuerwicklungen 4a oder 4b mit einem Anregungsstrom belegt wird, so dass der jeweilige Steuerkern 3a, 3b gesättigt wird und dann zur Einstellung eines dritten Messbereichs zur Messung von hohen Strömen beide Steuerkerne 3a, 3b durch Aufbringen von entsprechenden Steuerströmen auf die Steuerwicklungen 4a, 4b gesättigt werden. Das magnetfeldsensitive Bauteil 5 befindet sich dann in der Mitte des dadurch entstehenden fiktiven Luftspaltes.

In einer nicht gezeigten Ausführungsform ist weiterhin denkbar, dass mehr als nur zwei Steuerkerne in dem Luftspalt angeordnet sind und durch Kombination der jeweiligen Sättigungsströme bzw. durch Kombination der jeweiligen Sättigungen der Steuerkerne unterschiedliche Luftspaltlängen bezüglich des magnetfeldsensitiven Bauteils 5 erzeugt werden können. Hierdurch kann unter Umständen eine weitere Anpassung der Messbereichsumschaltung an die jeweils geforderten Messbereiche realisiert werden.

Die so aufgebaute Vorrichtung eignet sich aufgrund der großen Messbereichsumschaltung besonders zur Überwachung von Strömen in Kraftfahrzeugen.

## Patentansprüche

1. Vorrichtung zur Messung eines in einem elektrischen Leiter fließenden Stroms mit einem einen Luftspalt (20) aufweisenden Magnetkreis (2) zur Kopplung mit dem elektrischen Leiter (1), mit einem im Luftspalt des Magnetkreises angeordneten magnetfeldsensitiven Bauteil (5) zur Messung des vom elektrischen Leiter erzeugten Magnetfelds, **dadurch gekennzeichnet, dass** in dem Luftspalt des Magnetkreises zwei Steuerkerne (3a, 3b) zur Steuerung des Luftspalts angeordnet sind, wobei die Steuerkerne jeweils eine Steuerwicklung (4a, 4b) zur magnetischen Sättigung des jeweiligen Steuerkerns zur Steuerung der effektiven Länge des Luftspalts aufweisen und das magnetfeldsensitive Bauteil zwischen den Steuerkernen angeordnet ist.

2. Vorrichtung nach Anspruch 1, **dadurch gekennzeichnet, dass** die Steuerkerne eine erste Sättigungsmagnetisierung aufweisen und der Magnetkreis eine zweite Sättigungsmagnetisierung aufweist und die erste Sättigungsmagnetisierung größer, kleiner oder gleich der zweiten Sättigungsmagnetisierung ist.

3. Vorrichtung nach Anspruch 2, **dadurch gekennzeichnet, dass** die beiden Steuerkerne unterschiedliche Sättigungsmagnetisierungen aufweisen.

4. Vorrichtung nach einem der vorstehenden Ansprüche, **dadurch gekennzeichnet, dass** der Magnetkreis den elektrischen Leiter im Wesentlichen umgreift.

5. Vorrichtung nach einem der vorstehenden Ansprüche, **dadurch gekennzeichnet, dass** der Magnetkreis einen im Wesentlichen quadratischen oder runden Querschnitt aufweist.

6. Vorrichtung nach einem der vorstehenden Ansprüche, **dadurch gekennzeichnet, dass** die Steuerkerne den Luftspalt des Magnetkreises im Wesentlichen ausfüllen.

7. Vorrichtung nach Anspruch 6, **dadurch gekennzeichnet, das** die Steuerkerne und das magnetfeldsensitive Bauteil den Luftspalt des Magnetkreises vollständig ausfüllen.

8. Vorrichtung nach einem der vorstehenden Ansprüche, **dadurch gekennzeichnet, dass** die beiden Steuerkerne im Wesentlichen gleiche Abmessungen aufweisen.

9. Vorrichtung nach einem der vorstehenden Ansprüche, **dadurch gekennzeichnet, dass** die Steuerkerne als Ferritkerne ausgebildet sind.

10. Vorrichtung nach Anspruch 9, **dadurch gekennzeichnet, dass** die Ferritkerne als rechteckige Rahmen ausgebildet sind, die auf mindestens einer Seite des Rahmens eine Steuerwicklung zur Sättigung des Ferritkerns tragen.

11. Vorrichtung nach Anspruch 10, **dadurch gekennzeichnet, dass** Steuerwicklungen auf zwei gegenüberliegenden Seiten des Rahmens angeordnet sind.

12. Vorrichtung nach Anspruch 10 oder 11, **dadurch gekennzeichnet, dass** die zwei Rahmen so ausgerichtet sind, dass die in den jeweiligen Rahmen liegenden Ebenen zueinander parallel sind.

13. Vorrichtung nach Anspruch 10 oder 11, **dadurch gekennzeichnet, dass** die zwei Rahmen so ausgerichtet sind, dass die in den jeweiligen Rahmen liegenden Ebenen senkrecht aufeinander stehen.

14. Vorrichtung nach einem der vorstehenden Ansprüche, **dadurch gekennzeichnet, dass** eine Auswertungsvorrichtung vorgesehen ist, die Steuermittel zur separaten Anregung der Steuerwicklungen aufweist.

15. Vorrichtung nach Anspruch 14, **dadurch gekennzeichnet, dass** die Auswertungsvorrichtung mit dem magnetfeldsensitiven Bauteil integriert ist.

16. Vorrichtung nach einem der vorstehenden Ansprüche, **dadurch gekennzeichnet, dass** die Vorrichtung im Bereich eines Masseleiters oder eines Plusleiters einer Fahrzeugbatterie, insbesondere einer Kraftfahrzeugbatterie, angeordnet ist.

17. Vorrichtung nach einem der vorstehenden Ansprüche, **dadurch gekennzeichnet, dass** die Vorrichtung im Bereich eines elektrischen Verbrauchers oder einer Gruppe elektrischer Verbraucher eines Fahrzeugs, insbesondere eines Kraftfahrzeugs, angeordnet ist.

18. Verfahren zum Messen eines in einem elektrischen Leiter fließenden Stroms mittels einer Vorrichtung gemäß einem der vorstehenden Ansprüche, **dadurch gekennzeichnet, dass** mindestens eine Messung des Magnetfeldes in dem Magnetkreis ohne Anregung der Steuerkerne und eine Messung des Magnetfeldes in dem Magnetkreis bei gesättigten Steuerkernen durchgeführt wird.

19. Verfahren nach Anspruch 18, **dadurch gekennzeichnet, dass** eine weitere Messung bei Sättigung nur eines einzigen Steuerkreises vorgenommen wird.

20. Verfahren nach Anspruch 19, **dadurch gekennzeichnet, dass** zunächst bei Sättigung des ersten Steuerkerns und dann bei Sättigung des zweiten Steuerkerns eine Messung vorgenommen wird.

21. Verwendung einer Vorrichtung gemäß einem der Ansprüche 1 bis 17 in einem Kraftfahrzeug zur Überwachung von Strömen im Bordnetz des Kraftfahrzeugs.

22. Verwendung eines Verfahrens gemäß einem der Ansprüche 18 bis 21 in einem Kraftfahrzeug zur Überwachung von Strömen im Bordnetz des Kraftfahrzeugs.

## Claims

1. Device for measuring a current flowing in an electrical conductor with a magnetic circuit (2) having an air gap (20) for coupling to the electrical conductor (1), with a magnetic field-sensitive component (5) arranged in the air gap of the magnetic circuit for measuring the magnetic field generated by the electrical conductor, **characterised in that** in the air gap of the magnetic circuit are arranged two control cores (3a, 3b) for control of the air gap, the control cores in each case having a control winding (4a, 4b) for magnetic saturation of the respective control core for control of the effective length of the air gap, and the magnetic field-sensitive component being arranged between the control cores.

2. Device according to claim 1, **characterised in that** the control cores have a first saturation magnetisation and the magnetic circuit has a second saturation magnetisation, and the first saturation magnetisation is greater than, less than or equal to the second saturation magnetisation.

3. Device according to claim 2, **characterised in that** the two control cores have different saturation magnetisation.

4. Device according to any of the preceding claims, **characterised in that** the magnetic circuit substantially encompasses the electrical conductor.

5. Device according to any of the preceding claims, **characterised in that** the magnetic circuit has a substantially square or round cross-section.

6. Device according to any of the preceding claims, **characterised in that** the control cores substantially fill the air gap of the magnetic circuit.

7. Device according to claim 6, **characterised in that** the control cores and the magnetic field-sensitive component completely fill the air gap of the magnetic circuit.

8. Device according to any of the preceding claims, **characterised in that** the two control cores have substantially the same dimensions.

9. Device according to any of the preceding claims, **characterised in that** the control cores are designed as ferrite cores.

10. Device according to claim 9, **characterised in that** the ferrite cores are designed as rectangular frames which on at least one side of the frame carry a control winding for saturation of the ferrite core.

11. Device according to claim 10, **characterised in that** control windings are arranged on two opposite sides of the frame.

12. Device according to claim 10 or 11, **characterised in that** the two frames are oriented in such a way that the planes lying in the respective frames are parallel to each other.

13. Device according to claim 10 or 11, **characterised in that** the two frames are aligned in such a way that the planes lying in the respective frames are perpendicular to each other.

14. Device according to any of the preceding claims, **characterised in that** there is provided an evaluating device which has control means for exciting the control windings separately.

15. Device according to claim 14, **characterised in that** the evaluating device is integrated with the magnetic field-sensitive component.

16. Device according to any of the preceding claims, **characterised in that** the device is arranged in the region of an earth conductor or a positive conductor of a vehicle battery, in particular a motor vehicle battery.

17. Device according to any of the preceding claims, **characterised in that** the device is arranged in the region of an electrical appliance or a group of electrical appliances of a vehicle, in particular a motor vehicle.

18. Method for measuring a current flowing in an electrical conductor by means of a device according to any of the preceding claims, **characterised in that** at least one measurement of the magnetic field in the magnetic circuit is performed without excitation of the control cores and one measurement of the magnetic field in the magnetic circuit is performed with the control cores saturated.

19. Method according to claim 18, **characterised in that** a further measurement is performed with saturation of only one control circuit.

20. Method according to claim 19, **characterised in that** first with saturation of the first control core and then with saturation of the second control core a measurement is performed.

21. Use of a device according to any of claims 1 to 17 in a motor vehicle for monitoring currents in the motor vehicle's electrical system.

22. Use of a method according to any of claims 18 to 21 in a motor vehicle for monitoring currents in the motor vehicle's electrical system.

## Revendications

1. Dispositif pour la mesure d'un courant s'écoulant dans un conducteur électrique avec un circuit magnétique (2) présentant une fente (20) pour le couplage avec le conducteur électrique (1), avec un composant sensible au champ magnétique (5) disposé dans la fente du circuit magnétique pour la mesure du champ magnétique engendré par le conducteur électrique, **caractérisé en ce que** deux noyaux de commande (3a, 3b) sont disposés dans la fente du circuit magnétique pour la commande de la fente, les noyaux de commande comportant chacun un enroulement de commande (4a, 4b) pour la saturation magnétique du noyau de commande respectif, pour la commande de la longueur efficace de la fente, et le composant sensible au champ magnétique étant disposé entre les noyaux de commande.

2. Dispositif selon la revendication 1, **caractérisé en ce que** les noyaux de commande présentent une première magnétisation de saturation et le circuit magnétique une deuxième magnétisation de saturation et **en ce que** la première magnétisation de saturation est plus grande que, égale à ou plus petite que la deuxième magnétisation de saturation.

3. Dispositif selon la revendication 2, **caractérisé en ce que** les deux noyaux de commande présentent des magnétisations de saturation différentes.

4. Dispositif selon l'une quelconque des revendications précédentes, **caractérisé en ce que** le circuit magnétique enserre sensiblement le conducteur électrique.

5. Dispositif selon l'une quelconque des revendications précédentes, **caractérisé en ce que** le circuit magnétique présente une section sensiblement carrée ou ronde.

6. Dispositif selon l'une quelconque des revendications précédentes, **caractérisé en ce que** les noyaux de commande remplissent sensiblement la fente du circuit magnétique.

7. Dispositif selon la revendication 6, **caractérisé en ce que** les noyaux de commande et le composant sensible au champ magnétique remplissent complètement la fente du circuit magnétique.

8. Dispositif selon l'une quelconque des revendications précédentes, **caractérisé en ce que** les deux circuits magnétiques présentent sensiblement les mêmes dimensions.

9. Dispositif selon l'une quelconque des revendications précédentes, **caractérisé en ce que** les noyaux de commande sont configurés comme noyaux de ferrite.

10. Dispositif selon la revendication 9, **caractérisé en ce que** les noyaux de ferrite sont configurés comme des cadres rectangulaires qui portent sur au moins un côté du cadre un enroulement de commande pour la saturation du noyau de ferrite.

11. Dispositif selon la revendication 10, **caractérisé en ce que** les enroulements de commande sont disposés sur deux côtés opposés du cadre.

12. Dispositif selon l'une quelconque des revendications 10 ou 11, **caractérisé en ce que** les deux cadres sont orientés de telle sorte que les plans se trouvant dans les cadres respectifs sont parallèles les uns aux autres.

13. Dispositif selon l'une quelconque des revendications 10 ou 11, **caractérisé en ce que** les deux cadres sont orientés de telle sorte que les plans se trouvant dans les cadres respectifs sont perpendiculaires les uns aux autres.

14. Dispositif selon l'une quelconque des revendications précédentes, **caractérisé en ce qu'**il est prévu un dispositif d'évaluation qui comporte des moyens de commande pour une excitation séparée des enroulements de commande.

15. Dispositif selon la revendication 14, **caractérisé en ce que** le dispositif d'évaluation est intégré avec le composant sensible au champ magnétique.

16. Dispositif selon l'une quelconque des revendications précédentes, **caractérisé en ce que** le dispositif est placé au voisinage d'une tresse de masse ou d'un conducteur positif d'une batterie de véhicule, en particulier d'une batterie de véhicule automobile.

17. Dispositif selon l'une quelconque des revendications précédentes, **caractérisé en ce que** le dispositif est placé au voisinage d'un consommateur électrique ou d'un groupe de consommateurs électriques d'un véhicule, en particulier d'un véhicule automobile.

18. Procédé pour la mesure d'un courant s'écoulant dans un conducteur électrique au moyen d'un dispositif selon l'une quelconque des revendications précédentes, **caractérisé en ce qu'**au moins une mesure du champ magnétique est effectuée dans le circuit magnétique sans excitation des noyaux de commande et une mesure du champ magnétique est effectuée dans le circuit magnétique avec les noyaux de commande saturés.

19. Procédé selon la revendication 18, **caractérisé en ce qu'**une autre mesure est effectuée avec la saturation d'un seul circuit de commande.

20. Procédé selon la revendication 19, **caractérisé en ce qu'**une mesure est effectuée d'abord avec la saturation du premier circuit de commande et ensuite avec la saturation du deuxième circuit de commande.

21. Utilisation d'un dispositif selon l'une quelconque des revendications 1 à 17 dans un véhicule automobile pour la surveillance des courants dans le réseau de bord du véhicule automobile.

22. Utilisation d'un procédé selon l'une quelconque des revendications 18 à 21 dans un véhicule automobile pour la surveillance des courants dans le réseau de bord du véhicule automobile.
